# EUROPÄISCHE PATENTSCHRIFT

(11) **EP 3 131 772 B1**
(45) Veröffentlichungstag und Bekanntmachung des Hinweises auf die Patenterteilung: **19.08.2020**
(21) Anmeldenummer: 15719156.0
(22) Anmeldetag: 10.04.2015
(51) Int. Cl.: B60H 1/00, H03K 17/96

(54) **BEDIENUNG EINER KLIMAANLAGE FÜR DEN INNENRAUM EINES KRAFTFAHRZEUGS**
OPERATOR CONTROL OF AN AIR-CONDITIONING SYSTEM FOR THE PASSENGER COMPARTMENT OF A MOTOR VEHICLE
COMMANDE DE LA CLIMATISATION DE L'HABITACLE D'UN VÉHICULE AUTOMOBILE

(30) Priorität: 17.04.2014 DE 102014207383
(43) Veröffentlichungstag der Anmeldung: 22.02.2017
(73) Patentinhaber: Bayerische Motoren Werke Aktiengesellschaft, 80809 München (DE)
(72) Erfinder: MIEDL, Florian, 80803 München (DE); SAPPLER, Anton, 81369 Muenchen (DE); GERSTL, Thomas, 80807 München (DE); TILLE, Thomas, 81249 Muenchen (DE)
(86) Internationale Anmeldenummer: PCT/EP2015/057797
(87) Internationale Veröffentlichungsnummer: WO 2015/158614

(56) Entgegenhaltungen:
- EP-A2- 1 291 205
- WO-A1-2006/027259
- WO-A1-2009/143924
- WO-A1-2013/041946
- WO-A1-2014/026854
- DE-A1-102008 046 625
- DE-A1-102010 010 441
- KR-A- 20120 061 218
- US-A1- 2003 102 120
- US-A1- 2005 133 347

## Beschreibung

Die Erfindung betrifft eine Klimaanlage für den Innenraum eines Kraftfahrzeugs, sowie ein Verfahren zum Betreiben der Klimaanlage.

Klimaanlagen für Kraftfahrzeuge, insbesondere PKW, sind wohlbekannt. Sie umfassen eine Einheit, die Luft mit der gewünschten Temperatur bereitstellt, sowie Luftführungen und Luftauslässe. Die Bedienung der Klimaanlage geschieht über Bedieneinheiten, die meist im Armaturenbrett des Kraftfahrzeugs angeordnet sind. Moderne Klimaanlagen erlauben die Einstellung einer Wunschtemperatur, deren Erreichung bzw. Einhaltung von der Klimaanlage mithilfe von Temperatursensoren überwacht wird und durch geeignete Wahl der Temperatur der ausströmenden Luft (Soll-Temperatur der ausströmenden Luft) sichergestellt wird. Die Bedienung der Klimaanlagen erfolgt meist über ein Bedienpanel, das über Drehknöpfe oder -regler verfügt, mit denen die Wunschtemperatur eingestellt wird.

Meist verfügen derartige Klimaanlagen über mehrere Luftauslässe im Innenraum des Fahrzeugs, von denen einige im Fußraum und einige im oberen Bereich des Armaturenbretts auf Höhe des Lenkrads angeordnet sind. Weiterhin können Luftauslässe auch zu Defrost-Zwecken eingesetzt werden und dazu beispielsweise direkt auf Fahrzeugscheiben gerichtet sein. Um den Insassen eine möglichst passende Temperierung zu ermöglichen, bieten derzeitige Klimaanlage von einigen Fahrzeugen der BMW AG die Möglichkeit, über ein Rändel die Temperaturschichtung einzustellen. Ausgehend von der Wunschtemperatur und der durch die Klimaanlagen bestimmten Temperatur für die ausströmende Luft, wird dabei durch den Benutzer weiterhin die Temperaturdifferenz festgelegt, die zwischen der im Fußraum ausströmenden Luft und der auf Höhe des Lenkrads ausströmenden Luft besteht. So kann der Insasse des Fahrzeugs über das Rändel beispielsweise eine Temperaturschichtung einstellen, die eine höhere Ausströmtemperatur in Höhe des Lenkrads vorsieht, als im Fußraum. Alternativ kann durch das Rändel auch nur die Ausströmtemperatur in Höhe des Lenkrads verändert werden und die Ausströmtemperatur im Fußraum davon unbeeinflusst bleiben.

Die Bedienung der Temperaturschichtung geschieht, wie bereits ausgeführt, über ein Rändel. Es ist die Aufgabe der hierin beschriebenen Erfindung, eine alternative Bedieneinheit zur Temperaturschichtung bereitzustellen.

Dokument EP1291205 offenbart eine bekannte Klimaanlage für den Innenraum eines Kraftfahrzeugs. Die Aufgabe wird durch die Gegenstände der unabhängigen Ansprüche gelöst. Vorteilhafte Weiterbildungen sind in den abhängigen Ansprüchen definiert.

Ein Aspekt der Erfindung betrifft eine Klimaanlage für den Innenraum eines Kraftfahrzeug, wobei die Klimaanlage eine Bedieneinheit umfasst; wobei die Klimaanlage mindestens zwei Luftauslässe umfasst; wobei die Bedieneinheit einen berührungssensitiven Streifen umfasst; wobei die Klimaanlage zu Folgendem eingerichtet ist: Getrenntes Steuern der Temperatur der Luft, die aus dem ersten Luftauslass strömt, und der Temperatur der Luft, die aus dem zweiten Luftauslass strömt; Bestimmen der Temperatur der Luft für den ersten bzw. zweiten Luftauslass unabhängig voneinander und abhängig von erfassten Berührungen des Streifens. Typischerweise ist einer der Luftauslässe im Fußraum der Fahrgastzelle angeordnet und einer im Armaturenbrett auf Höhe des Lenkrades; ebenso kann einer der Luftauslässe auch zu Defrost-Zwecken vorgesehen sein, mit andren Worten; derart ausgerichtet sein, dass die Luft direkt auf Fahrzeugscheiben strömt. Hierdurch kann eine Defrost-Luftschicht-Ebene gebildet werden. Die Klimaanlage kann weitere Luftauslässe umfassen, wobei die weiteren Luftauslässe ebenso wie einer der zwei Luftauslässe mit Luft versorgt werden. Die Berührungssensitivität des Streifens kann unter Verwendung von im Stand der Technik bekannter Technologien realisiert werden, beispielsweise mithilfe von Widerstandsveränderungen (resistiv), optischen Effekten oder kapazitiven Effekten.

Hierin wird also vorgeschlagen das Bedienelement zur Temperaturschichtung als berührungssensitiven, also berührungsempfindlichen, Streifen auszuführen. Anstelle des Rändels wird somit dem Benutzer eine lineare Bedieneinheit zur Einstellung der Temperaturschichtung angeboten. Darüber hinaus erfolgt die Bedienung nicht über ein mechanisch bewegliches Element, sondern aufgrund einer erfassten Berührung. Die Ausgestaltung des Bedienelements als berührungssensitiver Streifen hat den Vorteil, dass die Lebensdauer des Bedienelements erhöht wird. Die Berührungssensitivität ermöglicht die Gestaltung der Bedieneinheit als geschlossene Fläche ohne Öffnungen, was die Reinigung erleichtert und eine Verschmutzung innerer Teile verhindert. Darüber hinaus wird die Bedienbarkeit der Vorrichtung auch nicht durch die mechanische Lebensdauer des Lagers oder des Drehmechanismus des Rändels und dessen Sensoren beeinträchtigt.

Der Streifen muss keine gleichmäße Ausdehnung in Querrichtung aufweisen, sondern kann entlang der Längsrichtung unterschiedlich "dick" sein. Weiterhin kann der Streifen eine bogenförmige Gestalt haben oder in einem Spezialfall ein Kreissegment darstellen und damit zumindest annäherungsweise einen Drehsteller nachbilden. Die Längs- und Querrichtung beziehen sich dann auf den Verlauf des Streifens und folgen dem Bogen oder dem Kreissegment. Der Streifen kann in seiner Form einen Drehsteller nachbilden. Der berührungssensitive Streifen kann auch allgemein als berührungssensitiver Bereich bezeichnet werden.

Der berührungssensitive Streifen kann aus einem Schichtaufbau bestehen, wobei die Berührung auf der obersten Schicht stattfindet. Typischerweise umfasst der Streifen zumindest eine Schicht zur Messung von Kapazitäten zwischen Elektroden und eine Schutzschicht. Darüber hinaus können auch Schichten vorgesehen sein, die der optisch ansprechenden Gestaltung dienen. Die oberste Schicht kann eine Ausdehnung und Gestalt aufweisen, die wesentlich größer ist, als die der Schicht zur Messung und insbesondere einen größeren, sichtbaren Teil eines Armaturenbretts bilden.

Der berührungssensitive Streifen kann angrenzend und unterhalb von Luftauslässen angeordnet sein, aber auch in einem von den Luftauslässen abgetrennten Bedienelement der Klimaanlage.

In einer vorteilhaften Ausgestaltung ist die Bedieneinheit zu Folgendem eingerichtet: In einem ersten Bereich: Erfassen der Position der Berührung des Streifens entlang einer Längsausdehnung des Streifens; wobei die Klimaanlage zu Folgendem eingerichtet ist: In Antwort auf das Erfassen einer Berührung im ersten Bereich des Streifens: Einstellen der Temperatur der Luft für den ersten und zweiten Luftauslass abhängig von der Position der Berührung entlang der Längsausdehnung des Streifens, wobei insbesondere die Temperatur des zweiten Luftauslassen auch unverändert bleiben kann. Hierin wird also eine Zuordnung der absoluten Position der Berührung bezogen auf die Längsausdehnung des Streifens und die Lufttemperatur vorgenommen. Dabei wird die Lufttemperatur für den ersten und den zweiten Luftauslass getrennt und unabhängig voneinander bestimmt. Es kann vorgesehen sein, dass die Temperatur für einen der Luftauslässe unverändert bleibt, während die Temperatur für den anderen Luftauslass geändert wird.

Typischerweise ist die eingestellte Temperatur der Luft für den ersten Luftauslass gegenüber einer Soll-Temperatur höher, wenn die Berührung in einer ersten Hälfte der Längsausdehnung des Streifens erfasst wird; wobei die eingestellte Temperatur der Luft für den ersten Luftauslass gegenüber einer Soll-Temperatur niedriger ist, wenn die Berührung in der zweiten Hälfte der Längsausdehnung des Streifens erfasst wird. Jeder Position entlang der Längsausdehnung des Streifens kann eine absolute Abweichung oder eine relative Abweichung (ein Faktor) gegenüber einer Soll-Temperatur der aus dem ersten Auslass strömenden Luft zugewiesen sein. Beispielsweise kann einer Berührung an einer ¾ Position, also bei 75% der Länge der Ausdehnung (gemessen vom einem Ende des Streifens), eine Temperaturerhöhung um 2°C oder um den Faktor 1,1 für den ersten Luftauslass zugewiesen sein. Die Soll-Temperatur der Luft für einen Auslass ergibt sich aus der Regelung der Innenraumtemperatur durch die Klimaanalage gemäß der vorgegebenen Wunschtemperatur, unter der Annahme, dass keine Änderung der Standardluftschichtung vom Benutzer eingegeben wurde.

In einer bevorzugten Implementierung ist die Bedieneinheit ferner zu Folgendem eingerichtet: Erfassen der Berührung eines zweiten Bereiches des Streifens, wobei der zweite Bereich an einem ersten Ende des Streifens angeordnet ist; Erfassen der Berührung eines dritten Bereiches des Streifens, wobei der dritte Bereich am zweiten Ende des Streifens angeordnet ist; wobei die Klimaanlage zu Folgendem eingerichtet ist: In Antwort auf das Erfassen einer Berührung im zweiten oder dritten Bereich des Streifens: Ändern der Temperatur der Luft für den ersten Luftauslass (ausgehend von der Soll-Temperatur) um einen dem jeweiligen Bereich zugewiesenen Wert oder Faktor und Ändern der Temperatur der Luft für den zweiten Luftauslass (ausgehend von der Soll-Temperatur) um einen anderen als den zugewiesenen Wert oder Faktor; wobei der dem zweiten Bereich zugewiesene Wert oder Faktor größer 0°C bzw. 1 ist und der dem dritten Bereich zugewiesene Wert oder Faktor kleiner 0°C bzw. 1 ist. Hierin wird also vorgeschlagen, dass bei Berührung der Enden des Streifens die Lufttemperatur ausgehend von der Soll-Lufttemperatur jeweils um einen Temperaturschritt erhöht oder erniedrigt wird. Dies wird manchmal auch als Toggeln bezeichnet. Der Temperaturschritt kann beispielsweise 1 °C sein. Dabei bezieht sich dieser Temperaturschritt auf die Lufttemperatur für den ersten Luftauslass. Die Temperatur für den zweiten Luftauslass ändert sich auf andere Weise, beispielsweise genau umgekehrt also z.B. -1°C oder auch auf andere Weise, z.B. - 1,5°C. Der zweite und dritte Bereich können jeweils von dem ersten Bereich abgesetzt sein. Es kann also ein Zwischenraum zwischen den jeweiligen Bereichen existieren, bei dessen Berührung keine Benutzereingabe erkannt wird.

Der Streifen kann einzelne Sensorflächen im ersten Bereich umfassen, die entlang der Längsausdehnung des Streifens in einer Reihe und typischerweise gleichmäßig beabstandet angeordnet sind. Mithilfe der Sensorflächen (die unter einer Schutz- und ggf. Dekorschicht liegen) wird die Berührung des Streifens erkannt, wozu kapazitive Effekte ausgenutzt werden. Die Erkennung einer Berührung wird mithilfe einer elektronischen Auswerteeinheit vorgenommen, die Teil der Bedieneinheit der Klimaanlage ist. Der Streifen umfasst typischerweise auch Sensorflächen in dem zweiten und dritten Bereich, wobei diese nicht unbedingt in einer derselben Reihe und im selben Abstand wie die Sensorflächen des ersten Bereiches angeordnet sein müssen.

Zusätzlich kann die Bedieneinheit weiterhin Leuchtelemente umfasst, die in einer Reihe angeordnet sind; und wobei die Klimaanlage ferner zu Folgendem eingerichtet ist: Aktivieren je eines oder mehrerer Leuchtelemente, derart, dass die Position des aktivierten bzw. der aktivierten Leuchtelemente in Bezug zur Längsausdehnung der Reihe die für den ersten Luftauslass bestimmte Lufttemperatur repräsentiert. Die Leuchtelemente sind typischerweise LEDs und können auch Lichtleiter umfassen. Hierin wird also vorgeschlagen, dem Benutzer eine optische Rückmeldung zu geben, welche Temperaturschichtung er gewählt hat. Diese Rückmeldung muss nicht unbedingt genaue Angaben zur Temperatur (in °C oder °F) machen, sondern kann auch rein relativ sein und nur die gerade gewählte Einstellung in Bezug auf den gesamt möglichen Einstellungsbereich. Dies wird durch die relative Positionierung des aktivierten Elements zur Gesamtausdehnung (in Längsrichtung) des Streifens erreicht.

Die Reihe der Leuchtelemente kann sich mit dem berührungssensitiven Streifen zumindest teilweise in Längsausdehnung überlagern. Die optische Rückmeldung geschieht also an Stellen, an denen auch Eingaben gemacht werden können. Die Leuchtelemente sind typischerweise oberhalb und/oder neben der Sensoreinheit angeordnet damit man bei Berührung der Sensoreinheit die Leuchtelemente sehen kann.

In einer Variante umfasst der erste Bereich zwei nicht verbundene Teilbereiche und die Bedieneinheit ist ferner zu Folgendem eingerichtet: Erfassen der Berührung des Streifens in einem vierten Bereich; wobei der vierte Bereich in Längsausdehnung zwischen den zwei Teilbereichen des ersten Bereiches angeordnet ist; wobei die Klimaanlage zu Folgendem eingerichtet ist: In Antwort auf das Erfassen einer Berührung im vierten Bereich des Streifens: Einstellen der Temperatur der Luft für den ersten und zweiten Luftauslass auf die jeweilige vorhergehend bestimmte Soll-Temperatur. Auf diese Weise wird ein Rücksetzen in den Standardzustand ermöglicht und eine eventuell eingestellte Schichtverteilung aufgehoben. Der separate vierte Bereich ist vorzugsweise mittig zwischen den Enden des Streifens angeordnet.

In einem anderen Aspekt umfasst ein Kraftfahrzeug, insbesondere ein PKW, eine der vorstehend beschriebenen Klimaanlagen.

In wieder einem anderen Aspekt umfasst ein Verfahren zum Steuern der Temperaturschichtung einer Klimaanlage für den Innenraum eines Kraftfahrzeug, wobei die Klimaanlage eine Bedieneinheit umfasst; wobei die Klimaanlage mindestens zwei Luftauslässe umfasst; Wobei die Bedieneinheit einen berührungssensitiven Streifen umfasst: Getrenntes Steuern der Temperatur der Luft, die aus dem ersten Luftauslass strömt, und der Temperatur der Luft, die aus dem zweiten Luftauslass strömt; Bestimmen der Temperatur der Luft für den ersten bzw. zweiten Luftauslass unabhängig voneinander und abhängig von erfassten Berührungen des Streifens. Das Verfahren kann durch die Schritte weitergebildet werden, die eine der oben beschriebenen Klimaanlagen ausführt.

### KURZE BESCHREIBUNG DER ZEICHNUNGEN

Fig. 1 zeigt schematisch eine Klimaanlage gemäß einem Ausführungsbeispiel.
Fig. 2 zeigt schematisch eine Bedieneinheit gemäß einem Ausführungsbeispiel.
Fig. 3a, 3b, 4a und 4b erläutern schematisch die Funktion der Bedieneinheit gemäß Ausführungsbeispielen.

Gleiche Bezugszeichen beziehen sich auf sich entsprechende Elemente über die Figuren hinweg.

### DETAILLIERTE BESCHREIBUNG DER AUSFÜHRUNGSBEISPIELE

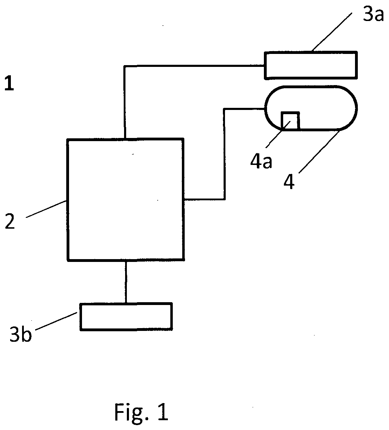

Fig. 1 zeigt schematisch eine Klimaanlage1 gemäß einem Ausführungsbeispiel. Die Klimaanlage 1 umfasst eine Einheit 2, die Luft mit der gewünschten Temperatur bereitstellt, sowie die Luftauslässe 3a und 3b. Der Luftauslass 3a befindet sich in der Mittelkonsole eines Armaturenbretts eines Fahrzeugs (nicht dargestellt) und ist über Luftführungen (beispielsweise Rohre) mit der Einheit 2 verbunden. Ein Luftauslass 3b ist im Fußraum der Fahrgastzelle angeordnet und ebenfalls über Luftführungen mit der Einheit 2 verbunden. Neben einem Bedienpanel (nicht dargestellt) zur Einstellung der Soll-Temperatur und weiterer Einstellmöglichkeiten der Klimaanlage, verfügt die Klimaanlage über eine Bedieneinheit 4. Die Bedieneinheit 4 ist unterhalb des Luftauslasses 3a angeordnet und umfasst auch eine elektronische Auswerteeinheit 4a, die Bedieneingaben an der Bedieneinheit 4 auswertet und an die Einheit 2 elektronisch berichtet. Die Klimaanlage 2 ist dazu ausgelegt im Rahmen der vorgegebenen Soll-Temperatur eine Temperatur-Schichtung vorzunehmen, d.h. die eigentlich von der Einheit 2 bestimmte jeweilige Temperatur der Luft für den jeweiligen Auslass 3a und 3b gemäß den Eingaben des Benutzers an der Bedieneinheit 4 anzupassen.

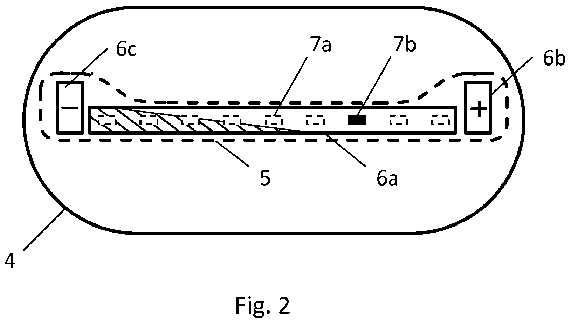

Fig. 2 zeigt schematisch eine Bedieneinheit 4 gemäß einem Ausführungsbeispiel. Die Bedieneinheit 4 umfasst einen berührungsempfindlichen Streifen 5, der hinter einer Blende angeordnet ist, so dass der Benutzer den Streifen 5 nicht erkennen kann (in Fig. 2 durch eine gestrichelte Darstellung angedeutet). Der empfindliche Streifen 5 umfasst einzelne Sensorelemente, die unterhalb der LEDs 7a angeordnet sind, aber im Bereich des Streifens 5 Berührungen erfassen können. In alternativen Ausführungsformen sind die Sensorelemente zwischen oder um die LEDs herum angeordnet; alternativ werden die Sensorelemente aus einem durchsichtigen Material gestaltet und können dann die LEDs auch überlagern.

Auf der Blende der Bedieneinheit wird ein erster Bereich 6a optisch angezeigt, beispielsweise durch eine Umrandung mit einer Linie. Ferner wird ein zweiter Bereich 6b und ein dritter Bereich 6c optisch angezeigt, ebenfalls beispielsweise durch eine Umrandung mit einer Linie. Die für Flächen 6a, 6b und 6c entstehenden geschlossenen Formen können auch mit einer Farbe ausgefüllt sein, beispielsweise rot oder blau. In dem Bereich 6a wird ferner durch eine Schraffierung ein Farbwechsel vom nicht-schraffierten Bereich zum schraffierten Bereich symbolisiert. Ebenfalls in der Bedieneinheit integriert sind LEDs 7a, 7b als Leuchtelemente. Die LEDs 7a sind im deaktivierten Zustand bei Betrachtung der Blende typischerweise nicht sichtbar (in Fig. 2 angedeutet durch eine gestrichelte Umrandung). Eine aktivierte LED 7b ist von außen als Lichtfleck sichtbar, was in Fig. 2 durch eine Ausfüllung angedeutet ist.

Im Betrieb wird durch die aktivierte LED der Zustand der Temperatur-Schichtung angezeigt. Vorliegend repräsentiert ein Schritt von einer LED zur nächsten eine Temperaturänderung von 1 °C der Luft für den Luftauslass 3a und eine entgegengesetzte Temperaturänderung um 1 °C (oder beispielsweise 0,7 °C) für den Luftauslass 3b. Ein Schritt in Richtung des Bereiches 6b repräsentiert eine Erhöhung der Lufttemperatur um 1 °C für den Luftauslass 3a, einem Schritt in Richtung des Bereiches 6c repräsentiert eine Temperaturerniedrigung um 1 °C für den Luftauslass 3a. Eine aktivierte LED in Mittelstellung der neun LEDs repräsentiert den Zustand, wenn keine Temperatur-Schichtung gemäß Benutzereingaben vorgenommen wird.

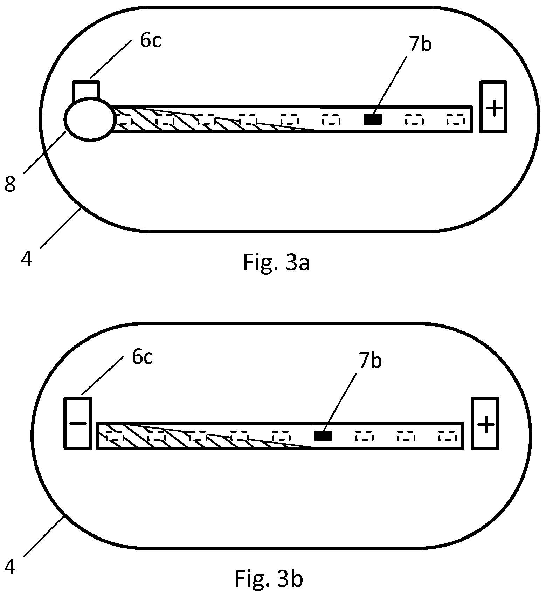

Fig. 3a und 3b erläutern schematisch die Änderung der Temperatur-Schichtung in Einzelschritten mithilfe Bedieneinheit 4. Im Betrieb erkennt mithilfe des berührungssensitiven Streifens die Bedieneinheit 4 eine Berührung 8 im Bereich 6c. In Antwort darauf wird die bisher für den jeweiligen Luftauslass vorgesehene Temperatur um 1 °C geändert: Die Temperatur der Luft für den Luftauslass 3a wird um 1 °C verringert und die Lufttemperatur für den Luftauslas 3b wird um 1 °C erhöht. Gleichzeitig wird die Aktivierung der LEDs verändert. Die bisher aktive LED 7b in Fig. 3a wird deaktiviert und die nächste LED in Richtung des Bereiches 6c wird aktiviert, so dass schließlich nur die LED 7b in Fig. 3b aktiviert ist. Die Bedieneingabe kann so lange wiederholt werden, bis die gewünschte Temperatur-Schichtung erreicht ist.

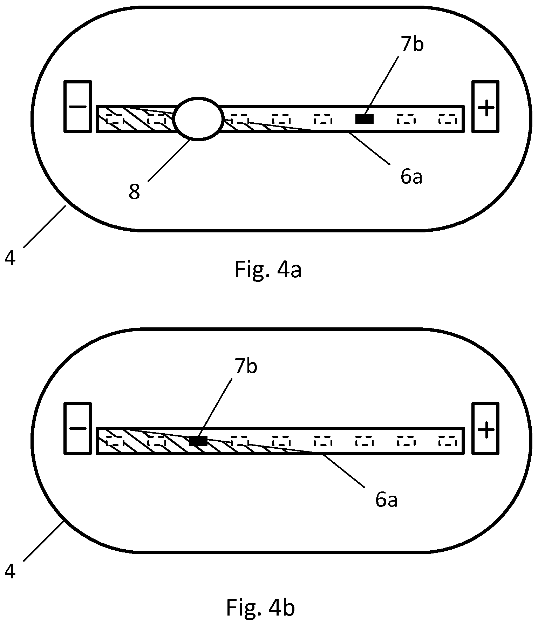

Fig. 4a und 4b erläutern schematisch die Änderung der Temperatur-Schichtung mithilfe der Bedieneinheit 4 durch direkte Wahl der Schichtung. Im Betrieb berührt hierzu der Benutzer die Stelle des Bereiches 6a, die der gewünschten Temperatur-Schichtung entspricht. In Fig. 4a wird der Bereich 6a an der Stelle 8 berührt. Entsprechend der Position der Berührung bezogen auf die ganze Längsausdehnung des Bereiches 6a, wird die Temperatur-Schichtung eingestellt. In Fig. 4a berührt der Benutzer die zweite LED links von der Mittenposition aus gesehen. Dies bedeutet, dass die Temperatur für den Luftauslass 3a um 2 °C gegenüber der von der Einheit 2 vorgesehenen Temperatur für den Luftauslass 3a verringert wird. Gleichzeitig wird die Temperatur für den Luftauslass 3b um 2 °C erhöht.

Die Berührung des Bereiches 6a in dessen Mitte der Längsausdehnung führt zur Aufhebung der Temperatur-Schichtung. Der Mittenbereich um die mittlere LED herum kann gesondert gekennzeichnet werden.

## Patentansprüche

1. Klimaanlage für den Innenraum eines Kraftfahrzeugs, wobei die Klimaanlage eine Bedieneinheit (4) umfasst; wobei die Klimaanlage mindestens zwei Luftauslässe (3a, 3b) umfasst;
Wobei die Bedieneinheit (4) einen berührungssensitiven Streifen (5) umfasst;
Wobei die Klimaanlage zu Folgendem eingerichtet ist:
- Erfassen einer Berührung des Streifens (5);
- Getrenntes Steuern der Temperatur der Luft, die aus dem ersten Luftauslass (3a) strömt, und der Temperatur der Luft, die aus dem zweiten Luftauslass (3b) strömt; **dadurch gekennzeichnet, dass** die Klimaanlage zu Folgendem eingerichtet ist:
- Bestimmen der Temperatur der Luft für den ersten und zweiten Luftauslass (3a, 3b) unabhängig voneinander und abhängig von der erfassten Berührung des Streifens (5).

2. Klimaanlage nach Anspruch 1,
wobei die Bedieneinheit (4) zu Folgendem eingerichtet ist:
- In einem ersten Bereich: Erfassen der Position der Berührung des Streifens (5) entlang einer Längsausdehnung des Streifens (5);
wobei die Klimaanlage zu Folgendem eingerichtet ist:
- In Antwort auf das Erfassen einer Berührung im ersten Bereich des Streifens (5): Einstellen der Temperatur der Luft für den ersten und auch den zweiten Luftauslass (3a, 3b) abhängig von der Position der Berührung entlang der Längsausdehnung des Streifens (5).

3. Klimaanlage nach Anspruch 2, wobei die eingestellte Temperatur der Luft für den ersten Luftauslass (3a) gegenüber einer Soll-Temperatur höher ist, wenn die Berührung in einer ersten Hälfte der Längsausdehnung des Streifens (5) erfasst wird; und wobei die eingestellte Temperatur der Luft für den ersten Luftauslass (3a) gegenüber einer Soll-Temperatur niedriger ist, wenn die Berührung in der zweiten Hälfte der Längsausdehnung des Streifens (5) erfasst wird.

4. Klimaanlage nach einem der Ansprüche 2 oder 3,
wobei die Bedieneinheit (4) zu Folgendem eingerichtet ist:
- Erfassen der Berührung eines zweiten Bereiches des Streifens (5), wobei der zweite Bereich an einem ersten Ende des Streifens (5) angeordnet ist;
- Erfassen der Berührung eines dritten Bereiches des Streifens (5), wobei der dritte Bereich am zweiten Ende des Streifens (5) angeordnet ist;
wobei die Klimaanlage zu Folgendem eingerichtet ist:
- In Antwort auf das Erfassen einer Berührung im zweiten oder dritten Bereich des Streifens (5): Ändern der Temperatur der Luft für den ersten Luftauslass (3a) um einen dem jeweiligen Bereich zugewiesenen Wert oder Faktor und Ändern der Temperatur der Luft für den zweiten Luftauslass (3b) um einen anderen als den zugewiesenen Wert oder Faktor;
- Wobei der dem zweiten Bereich zugewiesene Wert oder Faktor größer 0°C bzw. 1 ist und der dem dritten Bereich der zugewiesene Wert oder Faktor kleiner 0°C bzw. 1 ist.

5. Klimaanlage nach einem der Ansprüche 2 bis 4, wobei der Streifen (5) einzelne Sensorflächen im ersten Bereich umfasst, die entlang der Längsausdehnung des Streifens (5) in einer Reihe angeordnet sind.

6. Klimaanlage nach einem der vorhergehenden Ansprüche wobei die Bedieneinheit (4) weiterhin Leuchtelemente umfasst, die in einer Reihe angeordnet sind;
wobei die Klimaanlage ferner zu Folgendem eingerichtet ist:
- Aktivieren je eines oder mehrerer Leuchtelemente (7a, 7b), derart, dass die Position des aktivierten bzw. der aktivierten Leuchtelemente (7a, 7b) in Bezug zur Längsausdehnung der Reihe die für den ersten Luftauslass (3a) bestimmte Lufttemperatur repräsentiert.

7. Klimaanlage nach Anspruch 6, wobei die Reihe der Leuchtelemente (7a, 7b) sich mit dem berührungssensitiven Streifen (5) zumindest teilweise in Längsausdehnung überlagert.

8. Klimaanlage nach einem der Ansprüche 2 bis 5, wobei der erste Bereich zwei nicht verbundene Teilbereiche umfasst;
wobei die Bedieneinheit (4) ferner zu Folgendem eingerichtet ist:
Erfassen der Berührung des Streifens (5) in einem vierten Bereich; wobei der vierte Bereich in Längsausdehnung zwischen den zwei Teilbereichen des ersten Bereiches angeordnet ist;
wobei die Klimaanlage zu Folgendem eingerichtet ist:
In Antwort auf das Erfassen einer Berührung im vierten Bereich des Streifens (5): Einstellen der Temperatur der Luft für den ersten und zweiten Luftauslass (3a, 3b) auf die jeweilige vorhergehend bestimmte Soll-Temperatur.

9. Kraftfahrzeug, umfassend eine Klimaanlage nach einem der vorhergehenden Ansprüche.

10. Verfahren zum Steuern der Temperaturschichtung einer Klimaanlage für den Innenraum eines Kraftfahrzeug, wobei die Klimaanlage eine Bedieneinheit (4) umfasst; wobei die Klimaanlage mindestens zwei Luftauslässe (3a, 3b) umfasst; Wobei die Bedieneinheit (4) einen berührungssensitiven Streifen (5) umfasst; Wobei das Verfahren umfasst:
- Erfassen einer Berührung des Streifens (5);
- Getrenntes Steuern der Temperatur der Luft, die aus dem ersten Luftauslass (3a) strömt, und der Temperatur der Luft, die aus dem zweiten Luftauslass (3b) strömt;
- Bestimmen der Temperatur der Luft für den ersten und zweiten Luftauslass (3a, 3b) unabhängig voneinander und abhängig von der erfassten Berührung des Streifens (5).

## Claims

1. Air-conditioning system for the passenger compartment of a motor vehicle, wherein the air-conditioning system comprises an operator control unit (4), wherein the air-conditioning system comprises at least two air outlets (3a, 3b); wherein the operator control unit (4) comprises a touch-sensitive strip (5);
wherein the air-conditioning system is configured for the following:
- sensing contact with the strip (5);
- separate control of the temperature of the air which flows out of the first air outlet (3a), and of the temperature of the air which flows out of the second air outlet (3b), **characterized in that** the air-conditioning system is configured for the following:
- determining the temperature of the air for the first and second air outlets (3a, 3b) independently of one another and independently of the sensed contact with the strip (5).

2. Air-conditioning system according to Claim 1,
wherein the operator control unit (4) is configured for the following:
- in the first region: sensing of the position of the contact with the strip (5) along a longitudinal extent of the strip (5);
wherein the air-conditioning system is configured for the following:
- in response to the sensing of contact in the first region of the strip (5): setting the temperature of the air for the first and also for the second air outlet (3a, 3b) in accordance with the position of the contact along the longitudinal extent of the strip (5).

3. Air-conditioning system according to Claim 2,
wherein the temperature which is set for the air for the first air outlet (3a) is higher than a setpoint temperature if the contact is sensed in a first half of the longitudinal extent of the strip (5); and wherein the temperature which is set for the air for the first air outlet (3a) is lower than a setpoint temperature if the contact is sensed in the second half of the longitudinal extent of the strip (5).

4. Air-conditioning system according to one of Claims 2 and 3,
wherein the operator control unit (4) is configured for the following:
- sensing the contact with a second region of the strip (5), wherein the second region is arranged at a first end of the strip (5);
- sensing the contact with a third region of the strip (5), wherein the third region is arranged at the second end of the strip (5);
wherein the air-conditioning system is configured for the following;
- in response to the sensing of contact with the second or third region of the strip (5) : changing the temperature of the air for the first air outlet (3a) by a value or factor which is assigned to the respective region, and changing the temperature of the air for the second air outlet (3b) by a value of factor other than that assigned;
- wherein the value or factor which is assigned to a second region is higher than 0°C or 1, and the value or factor which is assigned to the third region is lower than 0°C or 1.

5. Air-conditioning system according to one of Claims 2 to 4, wherein the strip (5) comprises individual sensor faces in the first region, which faces are arranged in a row along the longitudinal extent of the strip (5) .

6. Air-conditioning system according to one of the preceding claims, wherein the operator control unit (4) also comprises lighting elements which are arranged in a row;
wherein the air-conditioning system is also configured for the following:
- activating in each case one or more lighting elements (7a, 7b) in such a way that the position of the activated lighting element or elements (7a, 7b) with respect to the longitudinal extent of the row represents the air temperature which is determined for the first air outlet (3a).

7. Air-conditioning system according to Claim 6, wherein the touch-sensitive strip (5) is superimposed on the row of lighting elements (7a, 7b), at least partially in the longitudinal extent.

8. Air-conditioning system according to one of Claims 2 and 5, wherein the first region comprises two unconnected part-regions;
wherein the operator control unit (4) is also configured for the following:
sensing the contact with the strip (5) in a fourth region; wherein the fourth region is arranged in a longitudinal extent between the two part-regions of the first region;
wherein the air-conditioning system is configured for the following:
in response to the sensing of contact in the fourth region of the strip (5): setting the temperature of the air for the first and second air outlets (3a, 3b) to the respective previously determined setpoint temperature.

9. Motor vehicle, comprising an air-conditioning system according to one of the preceding claims.

10. Method for controlling the temperature layering of an air-conditioning system for the passenger compartment of a motor vehicle, wherein the air-conditioning system comprises an operator control unit (4), wherein the air-conditioning system comprises at least two air outlets (3a, 3b); wherein the operator control unit (4) comprises a touch-sensitive strip (5); wherein the method comprises:
- sensing contact with the strip (5);
- separate control of the temperature of the air which flows out of the first air outlet (3a), and of the temperature of the air which flows out of the second air outlet (3b);
- determining the temperature of the air for the first and second air outlets (3a, 3b) independently of one another and in accordance with the sensed contact with the strip (5).

## Revendications

1. Système de climatisation destiné à l'habitacle d'un véhicule automobile, dans lequel le système de climatisation comprend une unité de commande (4) ; dans lequel le système de climatisation comprend au moins deux sorties d'air (3a, 3b) ;
dans lequel l'unité de commande (4) comprend une bande tactile (5) ;
dans lequel le système de climatisation est adapté pour :
- détecter un toucher sur la bande (5) ;
- commander séparément la température de l'air sortant par la première sortie d'air (3a) et la température de l'air sortant par la deuxième sortie d'air (3b) ;
**caractérisé en ce que** le système de climatisation est adapté pour :
- déterminer la température de l'air destiné aux première et deuxième sorties d'air (3a, 3b) indépendamment l'une de l'autre et en fonction du toucher détecté sur la bande (5) .

2. Système de climatisation selon la revendication 1, dans lequel l'unité de commande (4) est adaptée pour :
- dans une première zone : détecter la position du toucher sur la bande (5) le long d'une étendue longitudinale de la bande (5) ;
dans lequel le système de climatisation est adapté pour :
- en réponse à la détection d'un toucher dans la première zone de la bande (5) : régler la température de l'air destiné à la première et aussi à la deuxième sortie d'air (3a, 3b) en fonction de la position du toucher le long de l'étendue longitudinale de la bande (5).

3. Système de climatisation selon la revendication 2, dans lequel la température de consigne de l'air destiné à la première sortie d'air (3a) est plus élevée qu'une température de consigne lorsque le toucher est détecté dans une première moitié de l'étendue longitudinale de la bande (5) ; et dans lequel la température réglée de l'air destiné à la première sortie d'air (3a) est inférieure à une température de consigne lorsque le toucher est détecté dans la deuxième moitié de l'étendue longitudinale de la bande (5).

4. Système de climatisation selon l'une des revendications 2 ou 3,
dans lequel l'unité de commande (4) est adaptée pour :
- détecter le toucher sur une deuxième partie de la bande (5), dans lequel la deuxième partie est située à une première extrémité de la bande (5) ;
- détecter le toucher d'une troisième partie de la bande (5), dans lequel la troisième partie est située à une deuxième extrémité de la bande (5) ;
dans lequel le système de climatisation est adapté pour :
- en réponse à la détection d'un toucher sur la deuxième ou la troisième partie de la bande (5) : modifier la température de l'air destiné à la première sortie d'air (3a) d'une valeur ou d'un facteur associé à la zone respective et modifier la température de l'air destiné à la deuxième sortie d'air (3b) d'une valeur ou d'un facteur autre que la valeur ou le facteur associé ;
- dans lequel la valeur ou le facteur associé à la deuxième zone est respectivement supérieur à 0°C ou égal à 1, et la valeur ou le facteur associé à la troisième zone est respectivement inférieur à 0°C ou égal à 1.

5. Système de climatisation selon l'une des revendications 2 à 4, dans lequel la bande (5) comprend des surfaces de détection individuelles dans la première zone, qui sont agencées en rangée le long de l'étendue longitudinale de la bande (5).

6. Système de climatisation selon l'une des revendications précédentes, dans lequel l'unité de commande (4) comprend en outre des éléments d'éclairage qui sont disposés en rangée ;
dans lequel le système de climatisation est en outre adapté pour :
- activer respectivement un ou plusieurs éléments d'éclairage (7a, 7b) de manière à ce que la position du ou des éléments d'éclairage activés (7a, 7b) par rapport à l'étendue longitudinale de la rangée représente la température de l'air déterminée pour la première sortie d'air (3a).

7. Système de climatisation selon la revendication 6, dans lequel la rangée d'éléments d'éclairage (7a, 7b) se superpose au moins en partie à la bande tactile (5) dans son étendue longitudinale.

8. Système de climatisation selon l'une des revendications 2 à 5, dans lequel la première zone comprend deux sous-zones non reliées entre elles ;
dans lequel l'unité de commande (4) est en outre adaptée pour :
détecter le toucher sur la bande (5) dans une quatrième zone ; dans lequel la quatrième zone est agencée dans son étendue longitudinale entre les deux sous-zones de la première zone ;
dans lequel le système de climatisation est adapté pour :
en réponse à la détection d'un toucher dans la quatrième zone de la bande (5) : régler la température de l'air destiné aux première et deuxième sorties d'air (3a, 3b) à la température de consigne respective préalablement déterminée.

9. Véhicule automobile équipé d'un système de climatisation selon l'une des revendications précédentes.

10. Procédé de commande de la répartition de la température d'un système de climatisation destiné à l'habitacle d'un véhicule automobile, dans lequel le système de climatisation comprend une unité de commande (4) ; dans lequel le système de climatisation comprend au moins deux sorties d'air (3a, 3b) ; dans lequel l'unité de commande (4) comprend une bande tactile (5) ; dans lequel le procédé consiste à :
- détecter un toucher sur la bande (5) ;
- commander séparément la température de l'air sortant par la première sortie d'air (3a) et la température de l'air sortant par la deuxième sortie d'air (3b) ;
- déterminer la température de l'air destiné aux première et deuxième sorties d'air (3a, 3b) indépendamment l'une de l'autre et en fonction du toucher détecté sur la bande (5) .
